# EUROPÄISCHE PATENTSCHRIFT

(11) **EP 1 176 511 B1**
(45) Veröffentlichungstag und Bekanntmachung des Hinweises auf die Patenterteilung: **22.12.2004**
(21) Anmeldenummer: 01115392.1
(22) Anmeldetag: 26.06.2001
(51) Int. Cl.: G06F 11/20, G11C 29/00

(54) **Anordnung zur Redundanzimplementierung für Speicherbaustein**
Device for implementing redundancy in a memory module
Dispositif de mise en oeuvre de redondance dans un module mémoire

(30) Priorität: 18.07.2000 DE 10034928
(43) Veröffentlichungstag der Anmeldung: 30.01.2002
(73) Patentinhaber: Infineon Technologies AG, 81669 München (DE)
(72) Erfinder: Fischer, Helmut, 82024 Taufkirchen (DE); Kandolf, Helmut, 81669 München (DE); Lammers, Stefan, 81739 München (DE)
(74) Vertreter: Müller - Hoffmann & Partner

(56) Entgegenhaltungen:
- US-A- 5 430 679
- US-A- 5 642 316

## Beschreibung

Die vorliegende Erfindung betrifft eine Anordnung zur Redundanzimplementierung für einen Speicherbaustein mit mindestens einer Fuse-Bank zum Speichern der Adressen von defekten Leitungen, einem Vergleicher zum Vergleichen von Adressen, einem Predecoder sowie einem Decoder für die Leitung und einem Redundanzdecoder für eine redundante Leitung, wobei dem Vergleicher an einem ersten Eingang eine vom Predecoder predecodierte Adresse zugeführt ist und der Ausgang des Vergleichers an einen Abschalteingang des Decoders sowie den Eingang des Redundanzdecoders angeschlossen ist.

Bekanntlich können in Speicherbausteinen defekte oder fehlerhafte Leitungen durch fehlerfreie redundante Leitungen ersetzt werden, um so bei der Herstellung von Halbleiterbausteinen die Ausbeute zu steigern: Wird bei einem Test von Halbleiterbausteinen festgestellt, daß diese eine oder mehrere fehlerhafte Leitungen aufweisen, so werden diese fehlerhaften Leitungen durch redundante Leitungen ersetzt. Damit können Speicherbausteine mit fehlerhaften Leitungen dennoch als fehlerfrei eingesetzt werden.

Das Ersetzen einer fehlerhaften Leitung durch eine fehlerfreie redundante Leitung erfolgt in der Weise, daß die Adresse der defekten Leitung in einer Fuse-Bank abgespeichert wird. Erfolgt nun ein Speicherzugriff auf den Speicherbaustein, so wird jede angelegte Adresse mit der in den Fuse-Bänken abgelegten Adressinformation bitweise verglichen. Mit anderen Worten, es wird festgestellt, ob eine angelegte Adresse mit einer in den Fuse-Bänken abgelegten Adresse übereinstimmt.

Wird keine Übereinstimmung festgestellt, so erfolgt der "normale" Speicherzugriff auf den Speicherbaustein über einen Predecoder und einen Decoder.

Wird dagegen Übereinstimmung zwischen den beiden Adressen ermittelt, so werden der für einen "normalen" Speicherzugriff zuständige Predecoder bzw. Decoder deaktiviert, und ein Redundanzdecoder für die die fehlerhafte Leitung ersetzende fehlerfreie redundante Leitung wird aktiviert.

Es gibt nun verschiedene Möglichkeiten, eine Anordnung zur Redundanzimplementierung zu gestalten. Wesentlich für solche Redundanzimplementierungen ist dabei, ob in den Fuse-Bänken für die fehlerhaften Leitungen undecodierte Adressen oder predecodierte Adressen abgespeichert sind. Denn die Anordnung der Fuse-Bänke, der Platzbedarf der Anordnung zur Redundanzimplementierung und der Leistungsverbrauch während eines Zugriffes auf den Speicherbaustein hängen davon ab, ob undecodierte oder predecodierte Adressen in den Fuse-Bänken abgelegt sind.

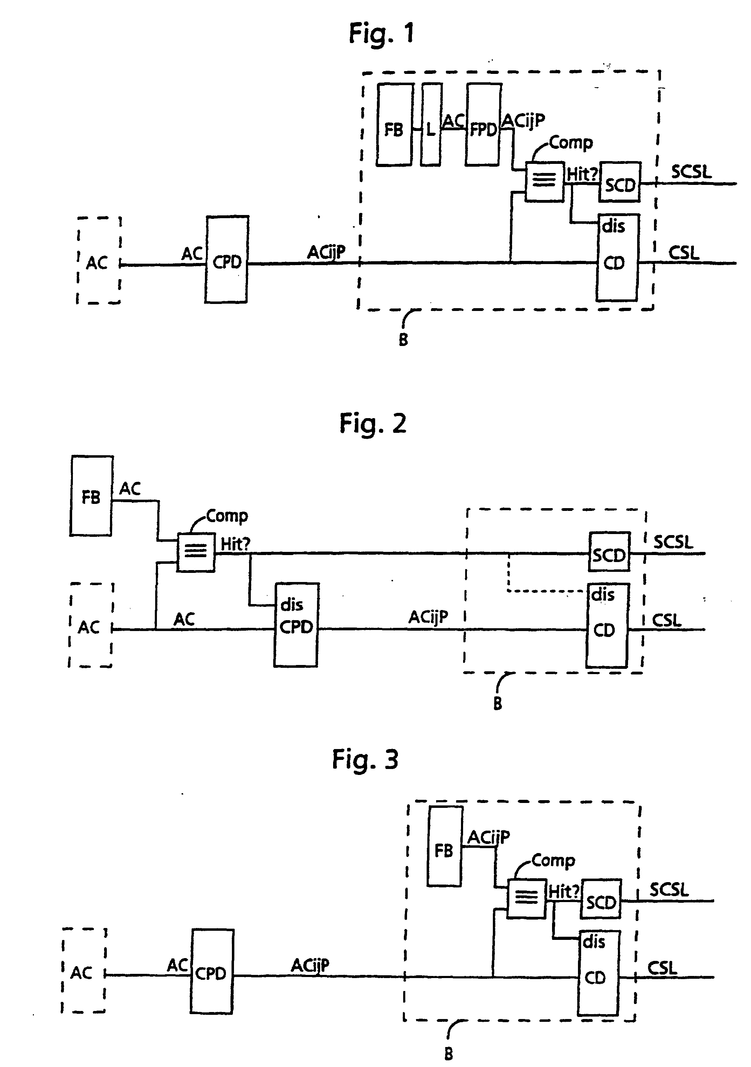

Dies soll im Folgenden anhand der Figuren 2 und 3 näher erläutert werden, die verschiedene Möglichkeiten darstellen, wie eine Anordnung zur Redundanzimplementierung bei Speicherbausteinen ausgeführt werden kann.

Bei der in Figur 2 dargestellten Anordnung werden in einer Speicherbank FB undecodierte Adressen von fehlerhaften Leitungen gespeichert, die durch redundante Leitungen zu ersetzen sind. Ist beispielsweise eine Leitung CSL von mehreren solchen Leitungen fehlerhaft, so wird diese Leitung durch ihre entsprechende redundante Leitung SCSL ersetzt. Erfolgt auf den Speicherbaustein ein Zugriff, so wird die mit diesem Speicherzugriff gelieferte undecodierte Adresse AC mit den in der Fuse-Bank FB abgelegten undecodierten Adressen in einem Vergleicher Comp verglichen. Das heißt, es wird ermittelt, ob eine Übereinstimmung ("Hit?") der Adressen vorliegt oder nicht. Stimmen nun beide Adressen überein, so werden ein Predecoder CPD und gegebenenfalls ein Decoder CD in der "normalen" fehlerhaften Leitung CSL deaktiviert ("dis"), und es wird ein Redundanzdecoder SCD in der redundanten Leitung SCSL ausgewählt. Der Decoder CD und der Redundanzdecoder SCD sind dabei vorzugsweise in einem Block B untergebracht. Der Speicherbaustein enthält selbstverständlich je nach Anzahl der redundanten Leitungen SCSL, die einem Block B zugeordnet sind, mehrere Fuse-Bänke FB.

Um nun Zugriffszeit einzusparen, kann bei der Anordnung von Figur 2 der Vergleich im Vergleicher Comp während des Predecodierens im Predecoder CPD vorgenommen werden. Im Falle einer Übereinstimmung der Adressen wird dann nur der Decoder CD deaktiviert ("dis"). Von Bedeutung ist dabei aber, daß der Decoder CD auf jeden Fall deaktiviert ist, bevor an ihm die vom Predecoder CPD gelieferten predecodierten Adressen ACijP anliegen.

Ein großer Vorteil des der Anordnung von Figur 2 zugrundeliegenden Konzeptes besteht in dem geringen Platzbedarf: In den Fuse-Bänken werden die undecodierten Adressen der fehlerhaften Leitungen abgespeichert, so daß eine nur geringe Anzahl an Fuses und zugeordneten Latches für jede Fuse-Bank benötigt wird. Nachteilhaft ist aber der relativ hohe Leistungsverbrauch, der bei der Anordnung von Figur 2 für jeden Zugriff auf eine redundante Leitung zwingend auftritt: Die Fuse-Bank FB und der Vergleicher Comp befinden sich relativ weit entfernt von dem Redundanzdecoder SCD, so daß bei jedem Zugriff auf eine redundante Leitung SCSL infolge der langen Leitungsstrecke eine große Kapazität aufgeladen werden muß.

Dieser Nachteil eines hohen Leistungsverbrauches pro Zugriff kann mit einer Anordnung vermieden werden, die in der in Figur 3 gezeigten Weise gestaltet ist. Hier sind die Fuse-Bänke FB nahe bei dem Redundanzdecoder SCD in dem Block B zusammen mit dem Vergleicher Comp und dem Decoder CD untergebracht, so daß keine weiteren langen Leitungen während eines Zugriffs auf die redundante Leitung SCSL getrieben werden müssen. Dadurch kann ohne weiteres Leistung eingespart werden. Nachteilhaft an dem der Figur 3 zugrundeliegenden Konzept der Redundanzimplementierung ist aber, daß in den Fuse-Bänken predecodierte Adressen ACijP der fehlerhaften Leitungen CSL abgespeichert werden müssen. Für diese Abspeicherung von predecodierten Adressen wird nämlich mehr Chipfläche als für die Abspeicherung von undecodierten Adressen benötigt. Dies bedeutet, daß bei der Anordnung von Figur 3 im Vergleich zur Anordnung von Figur 2 die Fuse-Bank FB erheblich größer ausgeführt werden muß, was auch für den zugehörigen Vergleicher Comp gilt.

Dokument US-A-5 642 316 offenbart eine Anordnung gemäß Figur 2 der vorliegenden Anmeldung.

Es ist Aufgabe der vorliegenden Erfindung, eine Anordnung zur leistungsarmen und platzsparenden Redundanzimplementierung für einen Speicherbaustein anzugeben.

Diese Aufgabe wird bei einer Anordnung der eingangs genannten Art erfindungsgemäß dadurch gelöst, daß der Ausgang der Fuse-Bank mit einem Redundanzpredecoder verbunden ist wobei die Fuse-Bank (FB) nahe bei dem Redundanzdecoder (SCD) in einem Block angeordnet ist, so daß in der Fuse-Bank die undecodierten Adressen abspeicherbar und dem Vergleicher an seinem zweiten Eingang die predecodierten Adressen der Fuse-Bank zuführbar sind.

Bei der erfindungsgemäßen Anordnung kann so die Fuse-Bank nahe bei dem Redundanzdecoder vorgesehen werden, so daß bei einem Zugriff auf eine redundante Leitung neben den Leitungen des Predecoders keine zusätzlichen langen Leitungen aufgeladen werden müssen. Vielmehr predecodiert bei der erfindungsgemäßen Anordnung der Redundanzpredecoder die in der Fuse-Bank gespeicherte Adresse. Damit ist es möglich, in der Fuse-Bank nur die undecodierten Adressen abzuspeichern, obwohl infolge der Einfügung des Predecoders in dem Vergleicher dann die predecodierten Adressen miteinander verglichen werden müssen. Damit kann die Fuse-Bank unter Verbrauch nur geringer Chipfläche ausgeführt werden.

Insgesamt ermöglicht so die Erfindung eine leistungsarme und platzsparende Redundanzimplementierung für einen Speicherbaustein.

Während eines Hochfahrens ("Power-Up") des Speicherbausteines werden die in den Fuse-Bänken gespeicherten Adressen in Latches gespeichert. Der Redundanzpredecoder predecodiert dann die einzelnen, in den Latches gespeicherten Adressen, sobald die jeweils gültigen Adressbits in diesen Latches abgelegt sind. Aus diesem Grund ist es möglich, für den Redundanzpredecoder einen platzsparenden, statischen Predecoder in den entsprechenden Block zu integrieren. Die Ausgangssignale des Redundanzpredecoders sind so lange gültig, bis der Speicherbaustein abgeschaltet ("Power-Down") wird.

Wesentlich an der erfindungsgemäßen Anordnung ist so der Einsatz des Redundanzpredecoders, der in einer Fuse-Bank abgelegte undecodierte Adressen predecodiert. Dadurch wird die für die Fuse-Bank benötigte Fläche minimiert. Außerdem kann die Fuse-Bank nahe bei dem Redundanzdecoder angeordnet werden, der die predecodierten Adressen decodiert, wodurch Leistung eingespart wird, da keine langen Leitungen von dem Vergleicher bis zu dem Redundanzdecoder vorgesehen werden müssen.

Nachfolgend wird die Erfindung anhand der Zeichnungen näher erläutert. Es zeigen:
Figur 1 ein Blockschaltbild der erfindungsgemäßen Anordnung,
Figur 2 ein Blockschaltbild einer ersten bestehenden Anordnung zur Redundanzimplementierung für einen Speicherbaustein, und
Figur 3 ein Blockschaltbild einer zweiten bestehenden Anordnung zur Redundanzimplementierung für einen Speicherbaustein.

Die Figuren 2 und 3 sind bereits eingangs erläutert worden.

In den Figuren werden für einander entsprechende Bauteile jeweils die gleichen Bezugszeichen verwendet.

Wie in Figur 1 gezeigt ist, werden undecodierte Adressen AC eines Speicherbausteines durch einen Predecoder CPD in predecodierte Adressen ACijP umgeformt. Diese predecodierten Adressen ACijP werden einem Block B zugeführt, in welchem Fuse-Bänke FB vorgesehen sind, in denen undecodierte Adressen von fehlerhaften Leitungen, also beispielsweise der Leitung CSL, abgelegt sind. Diese undecodierten Adressen AC werden in einem Redundanzpredecoder FPD in predecodierte Adressen ACijP umgewandelt. Die den Block B zugeführte predecodierte Adresse für die Leitung CSL wird sodann mit den predecodierten Adressen von der Fuse-Bank FB im Vergleicher Comp verglichen. Liegt Übereinstimmung vor, so wird ein Decoder der dann fehlerhaften Leitung CSL abgeschaltet ("dis"), und der Redundanzdecoder SCD decodiert dann die Adresse für die entsprechende redundante Leitung SCSL, so daß auf diese zugegriffen werden kann.

Auf diese Weise müssen bei der erfindungsgemäßen Anordnung nur undecodierte Adressen in der Fuse-Bank FB abgespeichert werden, obwohl sodann durch Einschaltung des Redundanzpredecoders FPD im Vergleicher Comp die predecodierten Adressen miteinander verglichen werden. Die Fuse-Bank FB ist nahe bei dem Redundanzdecoder SCD in dem Block B angeordnet, so daß bei einem Redundanzzugriff auf die redundante Leitung SCSL neben der langen Leitung des Predecoders CD keine zusätzlichen langen Leitungen aufgeladen werden müssen.

Insgesamt ist so eine platzsparende und leistungsarme Redundanzimplementierung möglich.

Wie bereits eingangs erläutert wurde, werden während des Hochfahrens des Speicherbausteines die in der Fuse-Bank FB gespeicherten Adressen in Latches L zwischengespeichert. Der Redundanzpredecoder FPD decodiert dann die einzelnen Adressen, sobald deren gültigen Adressbits in den Latches L abgelegt sind. Damit ist es möglich, für den Redundanzpredecoder FPD einen platzsparenden statischen Predecoder in dem Block B zu integrieren.

## Patentansprüche

1. Anordnung zur Redundanzimplementierung für Speicherbaustein mit mindestens einer Fuse-Bank (FB) zum Speichern der Adressen von defekten Leitungen (CSL), einem Vergleicher (Comp) zum Vergleichen von Adressen, einem Predecoder (CPD) sowie einem Decoder (CD) für die Leitung (CSL) und einem Redundanzdecoder (SCD) für eine redundante Leitung (SCSL), wobei dem Vergleicher (Comp) an einem ersten Eingang eine vom Predecoder (CPD) predecodierte Adresse (ACijP) zugeführt ist und der Ausgang des Vergleichers (Comp) an einen Abschalteingang (dis) des Decoders (CD) sowie den Eingang des Redundanzdecoders (SCD) angeschlossen ist,
**dadurch gekennzeichnet,**
**daß** der Ausgang der Fuse-Bank (FB) mit einem Redundanzpredecoder (FPD) verbunden ist wobei die Fuse-Bank (FB) nahe bei dem Redundanzdecoder (SCD) in einem Block angeordnet ist, so daß in der Fuse-Bank (FB) die undecodierten Adressen abspeicherbar und dem Vergleicher (Comp) an seinem zweiten Eingang die predecodierten Adressen der Fuse-Bank (FB) zuführbar sind.

2. Anordnung nach Anspruch 1,
**dadurch gekennzeichnet,**
**daß** die in der Fuse-Bank (FB) gespeicherten Adressen in Latches (L) speicherbar sind.

3. Anordnung nach Anspruch 1 oder 2,
**dadurch gekennzeichnet,**
**daß** der Redundanzpredecoder (FPD) ein statischer Predecoder ist.

4. Anordnung nach einem der Ansprüche 1 bis 3,
**dadurch gekennzeichnet**,
da**ß** der Ausgang des Vergleichers (Comp) mit einem Abschalteingang des Decoders (CD) verbunden ist.

5. Anordnung nach einem der Ansprüche 1 bis 4,
**dadurch gekennzeichnet,**
**daß** die Speicherbank (FB), der Redundanzpredecoder (FPD), der Vergleicher (Comp), der Redundanzdecoder (SCD) und der Decoder (CD) in einem Block (B) vorgesehen sind.

## Claims

1. Arrangement for implementing redundancy for a memory chip having at least one fuse bank (FB) for storing the addresses of defective lines (CSL), a comparator (Comp) for comparing addresses, a predecoder (CPD) and a decoder (CD) for the line (CSL) and a redundancy decoder (SCD) for a redundant line (SCSL) the comparator (Comp) being supplied at a first input with an address (ACijP) predecoded by the predecoder (CPD) and the output of the comparator (Comp) being connected to a disable input (dis) of the decoder (CD) and to the input of the redundancy decoder (SCD), **characterized in that** the output of the fuse bank (FB) is connected to a redundancy predecoder (FPD), the fuse bank (FB) being arranged close to the redundancy decoder (SCD) in a block, so that the undecoded addresses can be stored in the fuse bank (FB) and the comparator (Comp) can be supplied with the predecoded addresses of the fuse bank (FB) at its second input.

2. Arrangement according to Claim 1, **characterized in that** the addresses stored in the fuse bank (FB) can be stored in latches (L).

3. Arrangement according to Claim 1 or 2, **characterized in that** the redundancy predecoder (FPD) is a static predecoder.

4. Arrangement according to one of Claims 1 to 3, **characterized in that** the output of the comparator (Comp) is connected to a disable input of the decoder (CD).

5. Arrangement according to one of Claims 1 to 4, **characterized in that** the memory bank (FB), the redundancy predecoder (FPD), the comparator (Comp), the redundancy decoder (SCD) and the decoder (CD) are provided in a block (B).

## Revendications

1. Dispositif de mise en oeuvre de redondance pour module de mémoire, comportant au moins une bibliothèque (FB) de fusible pour mettre en mémoire les adresses de lignes (CSL) défectueuses, un comparateur (Comp) pour comparer des adresses, un prédécodeur (CPD), ainsi qu'un décodeur (CD) pour la ligne (CSL) et un décodeur (SCD) de redondance pour une ligne (SCSL) redondante, une adresse (ACijP) prédécodée par le prédécodeur (CPD) étant envoyé au comparateur (Comp) à une première entrée et la sortie du comparateur (Comp) étant raccordée à une entrée (dis) de déconnexion du décodeur (CD) ainsi qu'à l'entrée du décodeur (SCD) de redondance,
**caractérisé en ce que**
la sortie de la bibliothèque (FB) de fusible est reliée à un prédécodeur (FPD) de redondance, la bibliothèque (FB) de fusible étant montée dans un bloc à proximité du décodeur (SCD) de redondance, si bien que les adresses non décodées peuvent être mises en mémoire dans la bibliothèque (FB) de fusible et que les adresses prédécodées de la bibliothèque (FB) de fusible peuvent être envoyées au comparateur (Comp) à sa deuxième entrée.

2. Dispositif suivant la revendication 1,
**caractérisé en ce que**
les adresses mises en mémoire dans la bibliothèque (FB), de fusible peuvent être mises en mémoire dans des verrous (L).

3. Dispositif suivant la revendication 1 ou 2,
**caractérisé**
**en ce que** le prédécodeur (FPD) de redondance est un prédécodeur statique.

4. Dispositif suivant l'une des revendications 1 à 3,
**caractérisé en ce que**
la sortie du comparateur (Comp) est reliée à une entrée de déconnexion du décodeur (CD).

5. Dispositif suivant l'une des revendications 1 à 4,
**caractérisé en ce que**
la bibliothèque (FB) de mémoire, le prédécodeur (FPD) de redondance, le comparateur (Comp), le décodeur (SCD) de redondance et le décodeur (CD) sont prévus dans un bloc (B).
